# EUROPEAN PATENT APPLICATION

(11) **EP 3 361 504 A1**
(43) Date of publication of application: **15.08.2018**
(21) Application number: 17155978.4
(22) Date of filing: 14.02.2017
(51) Int. Cl.: H01L 23/544, H01L 23/373

(54) **POWER ELECTRONIC SUBSTRATE WITH MARKER, MANUFACTURING OF A POWER ELECTRONIC SUBSTRATE AND DETECTION OF A MARKER**

(71) Applicant: Infineon Technologies AG, 85579 Neubiberg (DE)
(72) Inventor: Schlinke, Wolfgang, 86899 Landsberg am Lech (DE); Rimbert-Riviere, Charles, 59494 Soest (DE)
(74) Representative: Westphal, Mussgnug & Partner Patentanwälte mbB

(57) **Abstract**

A power electronic substrate (150) includes a ceramic plate (10) with a surface and a marker pattern which is raised onto or generated in the surface of the ceramic plate. A method of manufacturing such a power electronic substrate includes raising a marker pattern onto a surface of a ceramic plate or generating the marker pattern in the surface of the ceramic plate. A method of detecting a pattern on a ceramic plate, wherein the pattern is covered by a metallization (31, 32), includes capturing the marker pattern by scanning acoustic microscopy ultrasonic scanning, laser scanning, thickness measurement of the first metallization or a combination thereof.

## Description

### TECHNICAL FIELD

The disclosure relates to a power electronic substrate with a marker pattern, a method for manufacturing such a power electronic substrate, and a method for detecting such a marker pattern.

### BACKGROUND

Common power electronic substrates (also herein referred to as substrates), which include an electrically isolating carrier and a structured metallization, are often equipped with marker patterns in order to allow for identification of each substrate during further processing of the substrate. Information on the model, type, characteristics or performance of the substrate, or parts included in or attached to it may be encoded by way of the marker pattern. Commonly a marker pattern corresponds to a certain code such as a bar code or a matrix code, and is disposed on the metallization of the substrate. However the marker pattern can deteriorate during further processing of the substrate, thereby deteriorating the readability of the code. Hence, there is a general desire for a power electronic substrate equipped with a marker pattern that is essentially stable during further processing of the substrate.

### SUMMARY

A power electronic substrate includes a ceramic plate with a surface and a marker pattern which is raised onto or generated in the surface of the ceramic plate.

A method of manufacturing such a power electronic substrate includes raising a marker pattern onto a surface of a ceramic plate or generating the marker pattern in the surface of the ceramic plate.

A method of detecting a pattern on a ceramic plate, wherein the pattern is covered by a metallization, includes capturing the marker pattern by scanning acoustic microscopy ultrasonic scanning, laser scanning, thickness measurement of the first metallization or a combination thereof.

### BRIEF DESCRIPTION OF THE DRAWINGS

Figure 1 is a schematic view of an exemplary power electronic substrate.
Figures 2-4 are images taken by way of a light microscope illustrating various marker patterns disposed on or integrated in different metallizations of substrates.
Figures 5-7 are images of detected marker patterns generated from the marker patterns shown in Figures 2-4 by way of an optical matrix-code reader.
Figure 8 is an image taken by way of a light microscope illustrating a marker pattern disposed on a surface of a ceramic carrier of a substrate.
Figure 9 is an image taken by way of a light microscope illustrating the marker pattern shown in Figure 8 after a sintering process applied to the substrate.
Figure 10 is an image of the marker pattern shown in Figure 8 taken by an optical matrix-code reader.
Figure 11 is an image of the marker pattern shown in Figure 9 taken by an optical matrix-code reader.
Figure 12 is a schematic diagram illustrating an exemplary method for manufacturing a power electronic substrate with a marker pattern on a surface of a ceramic plate serving as carrier of the substrate.
Figure 13 is a schematic view of the power electronic substrate manufactured according to the method illustrated in Figure 12.
Figure 14 is a schematic diagram illustrating a method of detecting a marker pattern by way of scanning acoustic microscopy.
Figure 15 is a flow chart illustrating an exemplary method of raising a marker pattern on a power electronic substrate.

### DETAILED DESCRIPTION

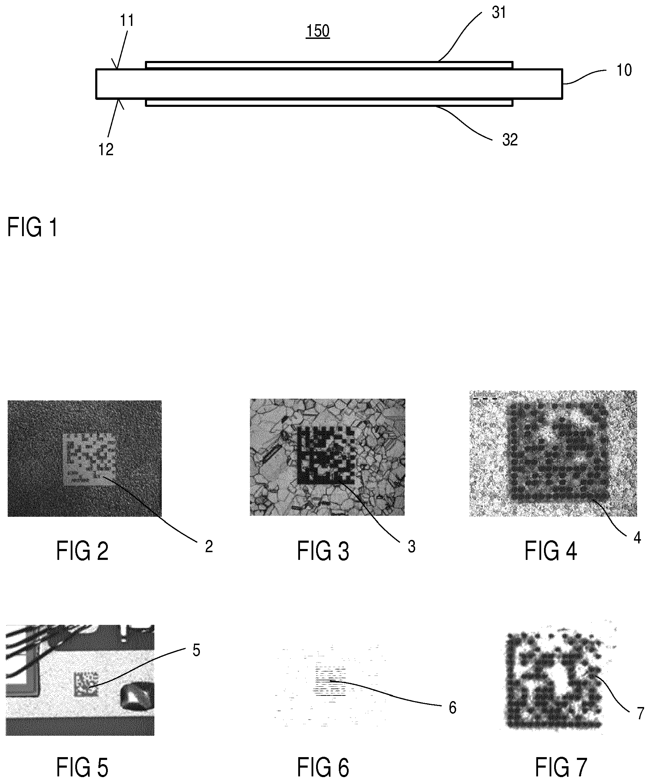

Referring to Figure 1, an exemplary (power electronic) substrate 150 includes a ceramic plate 10 serving as a carrier, which has a first surface 11 and a second surface 12 on opposite sides of the plate 10. The substrate 150 further includes a metallization 31 that is bonded onto the first surface 11 and/or the surface 12 of the ceramic plate 10. For example, the metallization 31 is a copper layer and the ceramic plate 10 is made of Al₂O₃, Si₃N₄, AIN, BN, or Zr toughened AIO. The substrate 150 may be of the type "direct copper bonded" (DCB) substrate or active metal brazing (AMB) substrate, and may be applied in a power semiconductor module. During the further processing of the substrate 150, such as during the manufacture of the power semiconductor module including, for example, dicing, sawing, drying, and/or sintering, it should be clearly identifiable. Therefore, the substrate 150 may be identified by an individual marker pattern (not shown in Figure 1), which may be any kind of pattern suitable for identifying substrate 150 (or parts of it).

Exemplary marker patterns are shown in Figures 2-14 and are raised onto or generated in the first surface 11 (alternatively or additionally on the second surface 12) of the ceramic plate 10. The exemplary marker patterns shown in Figures 2-11 are square-shaped patterns, known as matrix-code patterns, which are made up of distinguishable (e.g., black and white, high and low, etc.) sub-squares arranged according to the information to be encoded in the marker patterns, known as data matrix-code (DMC) patterns. Marker patterns may also include numerical sequences, letter sequences or combinations thereof. Further, matrix-code patterns may include patterns of several distinguishable (e.g., black and white, high and low, etc.) bars arranged parallel to one another, known as barcode patterns.

Figures 2-7 are images of marker patterns 2-7 disposed on or in a metallization of a substrate. The images in Figures 2-4 are taken by way of a light microscope in connection with a camera. The metallization is a copper layer in the substrate shown in Figure 2, a layer of copper and nickel in the substrate shown in Figure 3 or an alloy of copper and silver in the substrate shown in Figure 4. Further, Figure 4 shows the marker pattern 4 after being further processed, e.g., being exposed to heat within the context of a drying process of the substrate, in contrast to marker patterns before further processing (see Figures 2 and 3).

Figures 2-4 illustrate the different optical impressions made by the marker patterns 2, 3 and 4 dependent on the kind of metallization carrying the marker patterns 2, 3 and 4, dependent on the further processing steps performed, and the type of pattern detection. As can be seen, the impressions may significantly change dependent on the type of metallization and the applied further processing steps. Optical impression is understood to include the perception of, e.g., shape, contrast, brightness and sharpness of the marker pattern and its substructures. It can be seen from Figures 2-4 that particularly contrast and brightness of the captured marker patterns 2, 3 and 4 may vary significantly and it is apparent that the captured images of marker patterns 2, 3 and 4 may not fully correspond to the marker patterns originally applied to the metallization of the substrate. Therefore, due to a possibly distorted image detection of the marker patterns 2, 3 and 4 (e.g., pattern recognition) and subsequent decoding (e.g., transforming the recognized pattern into a matrix of binary information such as black and white) may lead to incorrect results.

From images of detected marker patterns 5, 6 and 7 shown in Figures 5-7, which were taken by an optical matrix-code reader from marker patterns 2, 3 and 4 shown in Figures 2, 3 and 4, it can be seen how difficult it is to capture, detect and decode patterns after further processing. An exemplary optical matrix-code reader (not shown) is designed to capture the images of the marker patterns 2, 3 and 4, e.g., by ways of an optical sensor, detect the marker patterns 2, 3 and 4 as detected marker patterns 5, 6 and 7, and decode the information coded in the detected marker patterns 5, 6 or 7 into a matrix of binary values (not shown) of e.g., "0" corresponding to bright areas and "1" corresponding to dark areas of the detected pattern. The optical matrix-code reader may alternatively or additionally include a light source that lights on the marker patterns before the camera captures an image of the reflected light by the marker patterns in order to optically enhance the contrast between dark and bright (black and white) sub-squares of the marker patterns 2, 3 and 4so that the detected marker patterns 5, 6 and 7 can more safely and accurately be decoded.

A copper layer was used as metallization in the substrate described in connection with Figures 2 and 5, a layer of copper and nickel in the substrate described in connection with Figures 3 and 6, and an alloy of copper and silver in the substrate described in connection with Figures 4 and 7. Furthermore, the substrate described in connection with Figure 7 an additional drying process during further processing of the substrate has been carried out. As can be seen, the impressions conveyed by the detected marker patterns 5, 6 and 7 in Figures 5-7 differ significantly from the original marker patterns 2, 3 and 4 shown in Figures 2-4 dependent, for example, on the type of metallization and on subsequent processing steps such as, e.g., dicing, sawing, drying, sintering etc..

From the images shown in Figures 2-7, it is apparent that it is difficult to maintain marker patterns on metallizations of substrates unaltered. In the following, examples of marker patterns arranged directly in or on power electronic substrates are described, which in contrast provide an essentially unaltered impression of the patterns even after further processing steps typical in the manufacture of power semiconductor modules.

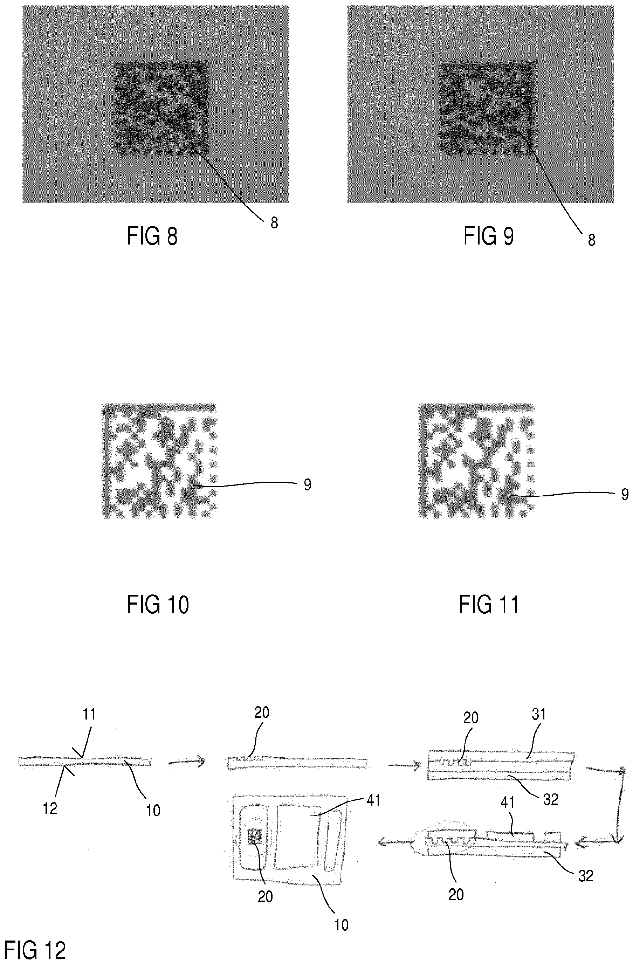

Figure 8 is an image of a marker pattern 8 applied by way of a laser into a surface of a ceramic plate of a substrate (not shown). The image of marker pattern 8 has been captured by way of a light microscope in connection with a digital camera. Figure 9 is an image illustrating the marker pattern 8 after further processing. The further processing may include bonding a metallization (not shown) on the ceramic plate, wherein the metallization does not cover the marker pattern 8. Further processing also includes in this example sintering of an integrated circuit (not shown) on the metallization. It can be seen that the structure of the marker pattern 8 is basically not affected by the high pressure and the high temperature occurring during further processing.

Figure 10 shows a marker pattern 9 lasered into a surface of a ceramic plate of an exemplary substrate (not shown). The black and white image of the marker pattern 9 has been taken by the same matrix-code reader mentioned above in connection with Figures 5-7. Figure 11 is an image of the marker pattern 9 captured after a metallization that does not cover the marker pattern 9 has been bonded to the ceramic plate and an integrated circuit has been sintered onto the metallization. It can be seen that the marker pattern 9 was not affected by high pressure and high temperature during further processing.

Further, marker patterns raised onto or generated in a surface of a ceramic plate of an exemplary power electronic substrate allow for power electronic substrates that require only little space. In contrast to common power electronic substrates in which the marker patterns are generated in or on a metallization of the ceramic plate, the marker patterns described above in connection with Figures 8-11 do not occupy space on the metallization so that the entire metallization area can be used for contacting active or passive electronic components such as, e.g., integrated circuits, capacitors, resistors, etc.

Figure 12 is a schematic diagram illustrating a sequence of process steps of an exemplary method for manufacturing a power electronic substrate. In this method, the ceramic plate 10 shown in Figure 1 with the first surface 11 and the second surface 12 is used, wherein the first surface 11 and the second surface 12 of the ceramic plate 10 are on opposite sides of the ceramic plate 10. To clearly identify the ceramic plate 10 amongst other ceramic plates (not shown), a marker pattern 20 is raised onto or generated in the first surface 11 of the ceramic plate 10. Additionally, a further marker pattern (not shown) may be provided, e.g., in or on the second surface 12 of the ceramic plate 10.

Information such as, e.g., a model number, a type characteristic, an order number, a customer number, a serial number or performance data of the ceramic plate 10 or the power electronic substrate may be encoded by way of the marker pattern 20.

For example, the marker pattern 20 may have a rectangular shape and a surface area between 1.5 and 3 mm², e.g. a length between 1 and 2 mm and a width between 1.5 and 2.5 mm. Depending on whether the marker pattern 20 is raised onto or generated in the first surface 11 of the ceramic plate 10, the marker pattern 20 may tower the first surface 11 or extend into the first surface 11 of the ceramic plate 10, e.g., with a relief hight in a range between 0.1 and 1 mm. The marker pattern 20 may be lasered, etched or milled into the first surface 11 of the ceramic plate 10. Alternatively, the marker pattern 20 may also be printed (e.g. 3D printing) on the first surface 11 of the ceramic plate 10. The same applies to the other marker patterns described in Figures 8 and 9.

As already described, the ceramic plate 10 may be at least partly equipped with a first metallization 31 (e.g., a bonded copper layer) on the first surface 11 of the ceramic plate 10. The first metallization 31 may alternatively be an alloy of copper and nickel or of copper and silver, and may not, partly or totally cover the marker pattern 20. If it covers the marker 20 at least partly, parts of the marker pattern 20 are no longer visible. For example, the first metallization 31 may be structured (e.g., by etching), and one or more predefined conductor paths 41 may remain on the first surface 11 and at least partly cover the marker pattern 20. In this case, parts of or the entire marker pattern 20 may be detected by scanning acoustic microscopy (SAM) analysis, ultrasonic scanning, laser scanning or thickness measurement of the first metallization 31 or a combination thereof. Scanning acoustic microscopy uses acoustic pulse reflection and includes an elctro-acoustic transducer that produces short sound pulses and an acoustic lens that transmits the short sound pulses with a high penetration rate and receives reflected short sound pulses. For example, a scanning acoustic microscope may include a sapphire cylinder with a sound transducer (e.g., a thin ZnO film) sputtered on its upper face and a cavity polished in the base opposite the transducer. The ZnO film, which forms a piezo-ceramic layer, converts high frequency electrical signals into sound, which is propagated as a plane-parallel wave field inside the sapphire. The cavity focuses the sound field on the sample under investigation, e.g., a marker, disposed in a coupling medium such as water. The immersion system including the cavity and the coupling medium may form the acoustic lens. The acoustic lens also receives sound pulses reflected from the sample during intervals between emission intervals, the transducer transforms the received sound pulses into electrical signals which can be displayed optically as separate pixels with defined grey values. In order to produce an image, the acoustic microscope scans the sample line by line. With scanning acoustic microscopy it is possible to clearly separate grating channels of an optical grating 0.4 µm apart. This means that the resolution of surface images produced by the acoustic microscope is comparable with that of a light microscope.

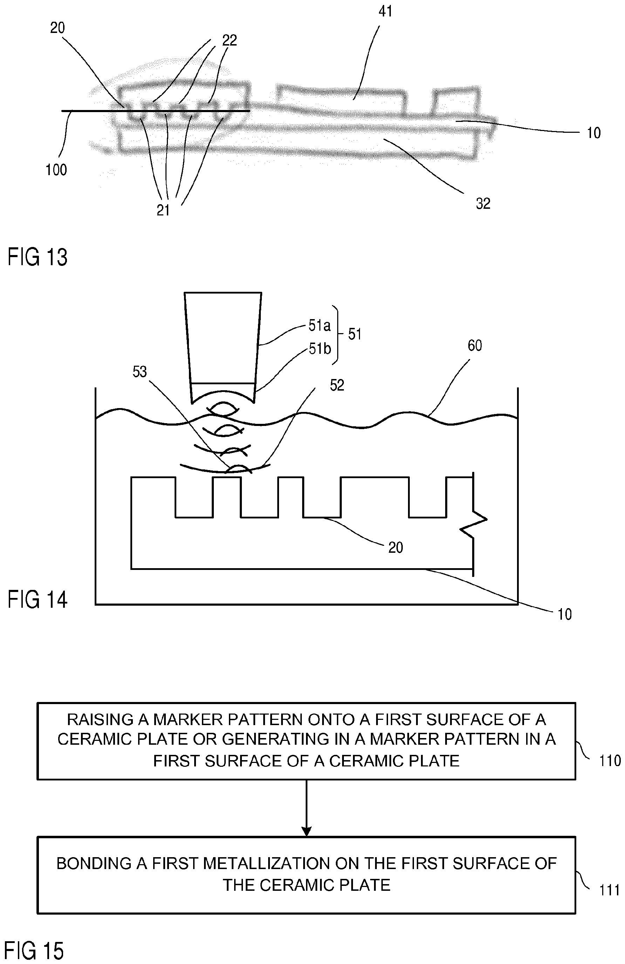

Referring to Figure 13, in an exemplary arrangement for scanning acoustic microscopy the substrate may be located in a fluid 60 such as water or the like. The arrangement includes an ultrasonic head 51 having a sound transducer 51 a and a concave acoustic lens 51 b which is arranged on one end of the sound transducer 51 a. The ultrasonic head 51 is moved in a predetermined distance and along a predetermined path over the first metallization 31 and, thus, also the marker pattern 20. When moving the ultrasonic head 51, ultrasonic waves 52 generated by the ultrasonic head 51 are guided into the fluid 60 and the fluid 60 guides the ultrasonic waves 52 into the substrate including the first metallization 31 and the ceramic plate 10.

Within the substrate, the ultrasonic waves 52 are reflected by interfaces between different materials and imperfections within the substrate. The intensity of the reflected ultrasonic waves 53 can be detected for several detecting positions along the predetermined path. The higher the number of detecting positions along the predetermined path, the higher the resolution of the captured marker pattern 20 by the scanning acoustic microscope. Additionally to the intensity, travel times of the reflected ultrasonic waves 53 can be measured. Based on the combination of intensity and travel time of the reflected ultrasonic waves 53, the position (e.g., depths) of the interfaces in the substrate can be determined.

The marker pattern 20 in the first surface 11 of the ceramic plate 10 is defined by the different interfaces between the material of the ceramic plate 10 and the material of the first metallization 31, e.g., the distance of the interface from the surface. The scanning acoustic microscope is, thus, able to detect the marker pattern 20 through the first metallization 31. Then, the pattern detected by the scanning acoustic microscope is subject to a pattern analysis to evaluate (decode) the information encoded in therein.

Scanning acoustic microscopy is commonly used to detect imperfections in power electronic substrates so that arrangements for scanning acoustic microscopy is already employed in the manufacturing process and, thus, can be readily used to detect the marker pattern 20. Decoding of the patterns can be performed in digital data processing arrangements that are commonly used in connection with scanning acoustic microscopes. Additionally or alternatively, a pattern may be disposed on a second metallization 32 on the second surface 12 of the ceramic plate 10. The second metallization 32 may be a copper layer or a layer of an alloy of copper and nickel or a layer of an alloy of copper and silver.

Figure 14 is a schematic view of an exemplary power electronic substrate in which the pattern is covered by a metallization. The power electronic substrate shown in Figure 14 includes the ceramic plate 10 with the first surface 11 and the second surface 12 as described before. A marker pattern 20 is engraved into in the first surface 11 of the ceramic plate 10 and the first metallization 31 is disposed in a structured manner on the first surface 11 of the ceramic plate 10. Additionally, the second metallization 32 is disposed in a structured manner on the second surface 12 of the ceramic plate 10. The marker pattern 20 is at least partly covered by the metallization 31 and is intended to be detected by scanning acoustic microscopy (SAM analysis), ultrasonic scanning, laser scanning or thickness measurement of the first metallization 31, or combinations thereof.

Figure 15 shows a flow chart illustrating an exemplary simple method of manufacturing a power electronic substrate of the type described before. In a first step 110 of the method, the marker pattern 20 is raised onto or generated in a first surface 11 of a ceramic plate 10. In a second step 112, a first metallization 31 may be bonded on the first surface 11 of the ceramic plate 10. Additionally, at least one further marker pattern may be raised onto or generated in a second surface 12 of a ceramic plate 10 and a second metallization 32 may be bonded on the second surface 12 of the ceramic plate 10.

The features mentioned in the single embodiments of the power electronic substrate may also be combined in different ways. Therefore, features may also be omitted or added in different embodiments of the power electronic substrate.

The description of embodiments has been presented for purposes of illustration and description. Suitable modifications and variations to the embodiments may be performed in light of the above description or may be acquired from practicing the methods. For example, unless otherwise noted, one or more of the described methods may be performed by a suitable device and/or combination of devices. The described methods and associated actions may also be performed in various orders in addition to the order described in this application, in parallel, and/or simultaneously. The described systems are exemplary in nature, and may include additional elements and/or omit elements.

As used in this application, an element or step recited in the singular and proceeded with the word "a" or "an" should be understood as not excluding plural of said elements or steps, unless such exclusion is stated. Furthermore, references to "one embodiment" or "one example" of the present disclosure are not intended to be interpreted as excluding the existence of additional embodiments that also incorporate the recited features. The terms "first," "second," and "third," etc. are used merely as labels, and are not intended to impose numerical requirements or a particular positional order on their objects.

While various embodiments of the invention have been described, it will be apparent to those of ordinary skilled in the art that many more embodiments and implementations are possible within the scope of the invention. In particular, the skilled person will recognize the interchangeability of various features from different embodiments. Although these techniques and systems have been disclosed in the context of certain embodiments and examples, it will be understood that these techniques and systems may be extended beyond the specifically disclosed embodiments to other embodiments and/or uses and obvious modifications thereof.

## Claims

1. A power electronic substrate comprising:
a ceramic plate (10) with a surface (11); and
a marker pattern (20) which is raised onto or generated in the surface (11) of the ceramic plate (10).

2. The power electronic substrate of claim 1, further comprising a metallization (31) which is bonded on the surface (11) of the ceramic plate (10), wherein the marker pattern (20) is at least partly covered by the metallization (31).

3. The power electronic substrate of claim 1 or 2, wherein the ceramic plate (10) comprises Al₂O₃, Si₃N₄, AIN or a Zr toughened AIO.

4. The power electronic substrate of any of claims 1-3, wherein the marker pattern (20) is a numerical sequence, a letter sequence, a pattern of strokes arranged parallel to one another, a square-shaped pattern comprising dark and bright sub-squares, or a combination thereof.

5. The power electronic substrate of claim 4, wherein the marker pattern has a rectangular shape and a surface area between 1.5 and 3 mm².

6. The power electronic substrate of any of claims 1-5, wherein information on at least model, type characteristics, performance and/or dimensions of the ceramic plate (10) or the power electronic substrate are encoded in the marker pattern (20).

7. The power electronic substrate of one of claims 1-6, wherein the metallization (31) is a copper layer or an alloy of copper and nickel or an alloy of copper and silver.

8. A method of manufacturing a power electronic substrate according to any of claims 1-7, the method comprising:
raising (110) a marker pattern (20) onto a surface (11) of a ceramic plate (10) or generating the marker pattern (20) in the surface (11) of the ceramic plate (10).

9. The method of claim 8, further comprising bonding (111) a metallization (31) on the surface (11) of the ceramic plate (10), wherein the marker pattern (20) is at least partly covered by the metallization (31).

10. The method of claim 8 or 9, further comprising:
etching the metallization (31) of the ceramic plate (10) to generate at least one conductor path (41) on the surface (11) of the ceramic plate (10).

11. The method of any of claims 8-10, wherein information on model, type characteristics, performance and/or dimensions of the ceramic plate (10) or the power electronic substrate are encoded in the marker pattern (20).

12. The method of any of claims 8-11, wherein the marker pattern (20) is lasered into the surface (11) of the ceramic plate (10).

13. A method of detecting a pattern (20) on a ceramic plate (10), the pattern (20) being covered by a metallization (31) and the method comprising:
capturing the marker pattern (20) by scanning acoustic microscopy ultrasonic scanning, laser scanning, thickness measurement of the first metallization (31) or a combination thereof.

14. The method of claim 13, wherein the marker pattern (20) is captured through the metallization (31).
